# EUROPEAN PATENT SPECIFICATION

(11) **EP 0 335 547 B1**
(45) Date of publication and mention of the grant of the patent: **28.06.1995**
(21) Application number: 89302721.9
(22) Date of filing: 20.03.1989
(51) Int. Cl.: H03K 5/135, H03K 5/01

(54) **A metastable prevention circuit**
Schaltung zur Verhinderung eines metastabilen Zustandes
Circuit pour la prévention d'état métastable

(30) Priority: 29.03.1988 US 174641
(43) Date of publication of application: 04.10.1989
(73) Proprietor: SEAGATE TECHNOLOGY INTERNATIONAL, Georgetown, Grand Cayman Island (KY)
(72) Inventor: Grivna, Edward Lewis, Brooklyn Park Minnesota (US)
(74) Representative: Sturt, Clifford Mark

(56) References cited:
- EP-A- 0 058 752
- US-A- 4 575 644
- IBM TECHNICAL DISCLOSURE BULLETIN vol. 27, no. 7a, December 1984, pages 3889, 3890, New York, US; O.R. BUHLER et al.: "Data synchronizer with parallel flip-flops"
- ELECTRO/87 AND MINI/MICRO NORTHEAST CONFERENCE RECORD vol. 12, 1987, pages 1 - 9, Los Angeles, CA, US; R.S. TETRICK: "System-Level Metastability Considerations"

## Description

This invention relates to metastable prevent circuits for eliminating the effects of metastable difference in digital circuits.

Digital latches and flip-flops respond to input signals to either remain in, or reverse, the output state. In either case, the output state is a stable condition. However, a condition known as metastability can exist in which the latch or flip-flop reaches a condition in which it lingers indefinitely between the two stable states. Ordinarily, this condition is caused by marginal triggering. If the latch or flip-flop is well balanced, the metastable condition may last until such internal or external imbalances affect the latch of flip-flop to cause it to go to one of its two stable states. While in the metastable condition, the output of the latch or flip-flop cannot be safely clocked. Consequently, metastability is a serious problem in high speed digital circuits used for synchronisation of asynchronous signals. More particularly, metastability is a significant problem in data recovery circuits employed in computer peripheral devices. In the past, attempts to prevent metastability have employed pair flip-flop circuits in which the output of a first flip-flop is clocked into a second. If the first flip-flop goes into a metastable state, it will, hopefully, recover in time for its output to be clocked into the second flip-flop. However, due to signal degradation in transmission of asynchronous information signals, the information may not be present at a time adequate to clock into the first flip-flop. As a result, although the clocking of the second flip-flop is intended to recover the information, the circuit might not respond to a badly degraded asynchronous signal. Consequently, an improvement has been to employ a pulse edge detector ahead of the first flip-flop to define more accurately the signal for the first flip-flop. Whilst these efforts have met with some degree of success in overcoming metastable conditions in digital circuits, they have not been completely successful at the reliability and speeds of current systems. An example of this type of metastable prevent circuit can be found in IBM Technical Disclosure Bulletin, Vol. 27, No. 7A, December 1984, Pages 3889, 3890.

According to the present invention there is provided a metastable prevent circuit comprising a plurality of channels disposed in parallel, each channel including a pulse edge detector and bistable means coupled to the output of said pulse edge detector, whereby said pulse edge detector is responsive to asynchronous pulses and said bistable means synchronises said asynchronous pulses to clock pulses of a synchronous clock signal, a selection means coupled to each channel for producing an enable signal to successively enable each one of the pulse edge detectors, characterised by the selection means being responsive to said asynchronous pulses.

Each of said pulse edge detector means may comprise third bistable means, and gate means responsive to the output of said first, second and third bistable means to reset said first and third bistable means. Said third bistable means preferably is either a gate enabled flip-flop having its enable input connected to an individual output of said shift means or is a J - K flip-flop having its J input connected to an individual output of said shift means. Alternatively, said third bistable means is a D-type flip-flop having its D input connected to an individual output of said shift means.

The circuit may include OR gate means having a first input connected to said individual output of said shift means, a second input connected to the true output of said D-type flip-flop, and an output connected to said D-input.

The invention is illustrated, merely by way of example, in the accompanying drawings, in which:-
Figure 1 is a block diagram of a typical known metastable prevent circuit;
Figure 2 is a diagram of waveform useful in explaining the operation of the circuit illustrated in Figure 1;
Figure 3 is a block circuit diagram of another known metastable prevent circuit;
Figure 4 is a diagram of waveforms used for explaining the operation of the circuit illustrated in Figure 3;
Figure 5 is a block circuit diagram of a metastable prevent circuit according to the present invention;
Figure 6 is a diagram of waveforms useful in explaining the operation of the circuit illustrated in Figure 5; and
Figures 7 and 8 are illustrations of further embodiments of metastable prevent circuits according to the present invention.

Throughout the drawings, like parts have been designated by the same reference numerals.

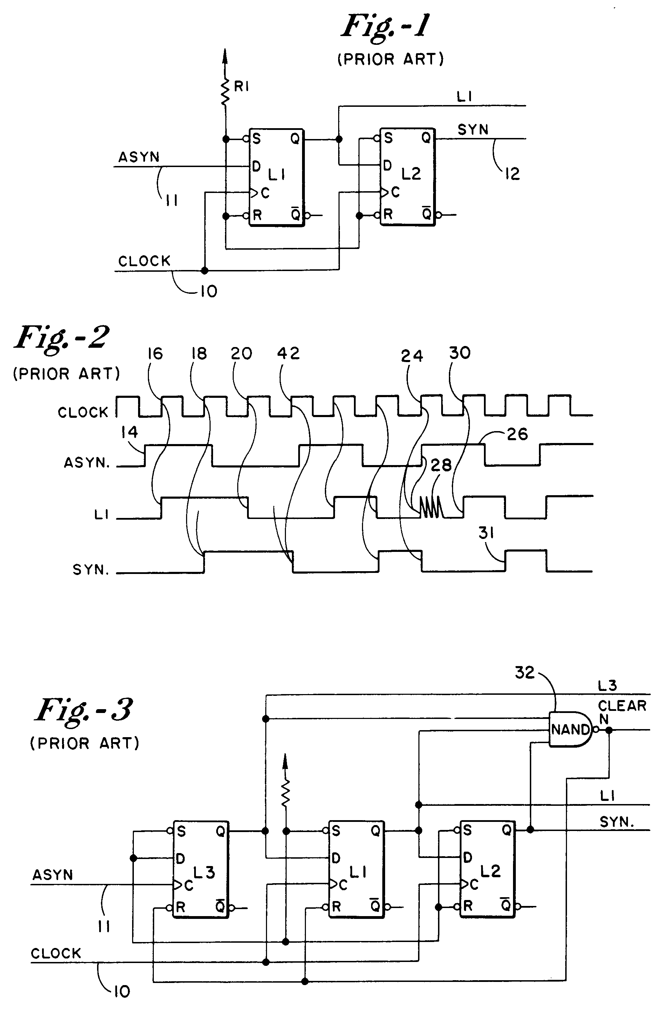

Referring to the drawings, particularly to Figure 1, there is illustrated a typical known metastable prevent circuit. The metastable prevent circuit employs a pair of D-type flip-flops L1, L2 having their set inputs and re-set inputs connected through a resistor R1 to a source of potential. The clock inputs of both flip-flops receive synchronous clock signals via a lead 10 whilst an asynchronous signal is provided via a lead 11 to the D input of the flip-flop L1. The Q output of the flip-flop L1 is provided to the D input of the flip-flop L2, and a synchronous output signal is provided on a lead 12 from the Q output of the flip-flop L2. The asynchronous signal may contain or validate digital information or may itself be an asynchronous clock signal.

The operation of the circuit illustrated in Figure 1 will be explained with reference to Figure 2. Upon receipt of an asynchronous pulse 14, the D input of the flip-flop L1 goes high. Upon the next rising edge 16 of the clock signal on the lead 10, the Q output of the flip-flop L1 is forced high, thereby providing a high input to the D input of the flip-flop L2. Upon the next rising edge 18 of the clock signal, the flip-flop L2 is forced to provide a high output, as shown. The flip-flop L1 is forced low upon a rising edge 20 of the next clock signal after the asynchronous pulse 14 goes low, and the synchronous output signal on lead 12 is forced low upon a rising edge 42 of the next clock pulse after the flip-flop L1 goes low.

Referring particularly to a clock pulse 24 and an asynchronous pulse 26, these two pulses have their leading edges occurring at approximately the same time, causing a marginal triggering of the flip-flop L1. As a result, the flip-flop L1 enters a metastable state resulting in a non-standard logic level, such as rapid switching between two stable states of a flip-flop as illustrated by a signal 28. Eventually, circuit imbalances and other external factors will force the flip-flop L1 arbitrarily to seek one of its two stable states. If the flip-flop L1 falsely seeks its lower state as shown in Figure 2, a leading edge 30 of the next clock pulse (with the asynchronous pulse 26 still high) will force the flip-flop L1 to its high or true condition, thereby establishing a synchronous output pulse 31.

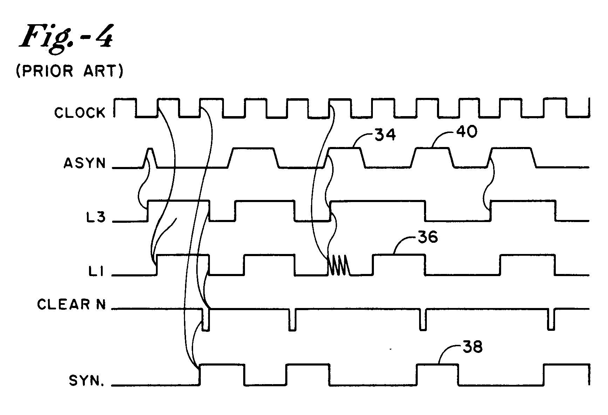

In most computer disk drives, the reliance on asynchronous logic is maintained at a minimum and is generally located at interfaces between separate equipment. In most cases, these interfaces are separated by relatively short distances. However, when signals are transmitted over substantial distances, distortion may result. The distortion may result in pulse shrinkage, expansion, pulse edge slow down and pulse to pulse position and period variations. In high speed data communications, the distortion may be so radical that data may not be reliably recaptured. To improve on the reliability of data transmission, it has been common to employ a pulse edge detector as illustrated in Figure 3. In particular, a D-type flip-flop L3 is added as a pulse edge detector to the circuit of Figure 1 for receiving the asynchronous signal on the lead 11. As illustrated particularly in Figure 4, the asynchronous signal may be of variable width and position, due to external factors, including transmission. A NAND gate 32 receives the outputs from the Q output of each of the flip-flops L1, L2, L3 to provide a signal output to the re-set inputs of the flip-flops L1, L3.

In operation of the circuit illustrated in Figure 3, and with reference to Figure 4, when the asynchronous signal on the lead 11 goes high relative to the clock pulse of the flip-flop L3, the Q output of the flip-flop L3 is forced high so that upon the next rising edge of a clock pulse on the lead 10 the Q output of the flip-flop L1 goes high. Upon the rising edge of the next successive clock pluse, with the Q output of the flip-flop L1 high, the Q output of the flip-flop L2 goes high to force the synchronous output signal on lead 12 high. Since the Q outputs of all the flip-flops L1, L2, L3 are high, the NAND gate 32 operates to provide a low signal re-set pulse to the re-set inputs R of the flip-flops L1, L3. With the Q output of the flip-flop L1 now in a low state, the rising edge of the next clock pulse will re-set the flip-flop L2 to force the synchronous output signal low.

As described in connection with the circuit illustrated in Figure 1, a metastable condition can exist. When the clock pulse and the asynchronous pulse are so close that the flip-flop L3 is forced high at about the same time that the leading edge of a synchronous clock pulse goes high, a risk of metastability exists. Thus, as in the case of the circuit illustrated in Figure 1, if the flip-flop L1 ultimately seeks a low stable state, it will not respond to an asynchronous pulse 34 until the next rising clock pulse to set the Q output pulse 36 of the flip-flop L1 high. A synchronous pulse 38 is derived from the output pulse 36 which, in turn, is derived from the asynchronous pulse 34. However, as illustrated in Figure 4, the next asynchronous pulse 40 has occurred while the output pulse 36 of the flip-flop L1 was high. Due to the already high condition of the flip-flop L3, the asynchronous pulse 40 is ignored, and the synchronous output signal does not include a pulse derived from the asynchronous pulse 40. Hence data is lost. (While a high clock frequency might seemingly enable recovery of the otherwise lost asynchronous pulse, higher frequencies also create other problems, including increased incidents of error due to metastability).

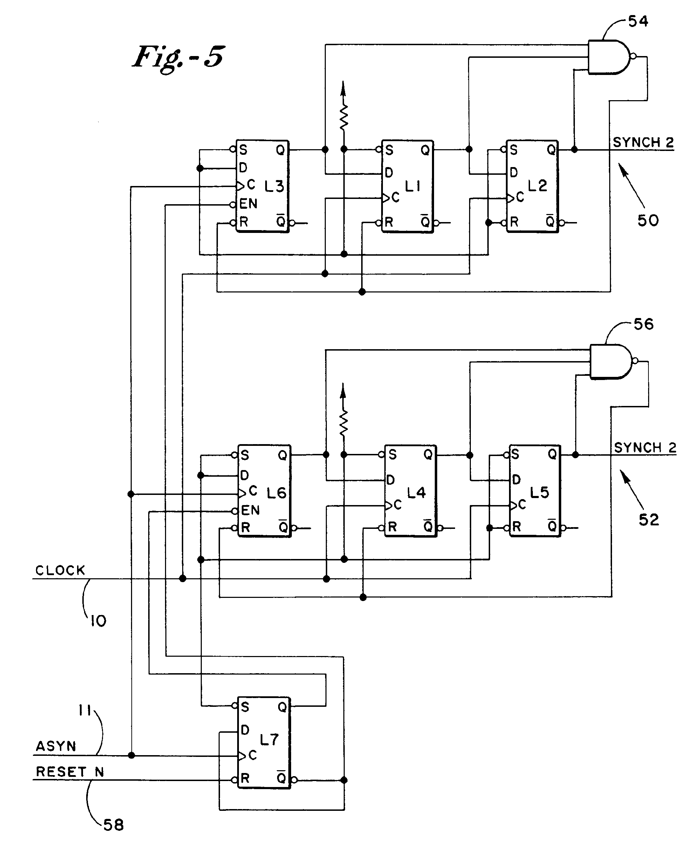

Referring to Figure 5, there is illustrated a metastable prevent circuit according to the present invention. As will be understood from the discussion of the operation of the circuit illustrated in Figure 5, this circuit overcomes the disadvantages of the known circuits illustrated in Figures 1 and 3. Thus with reference to Figure 5, there is illustrated two parallel channels 50, 52, each similar to the circuit illustrated in Figure 3. The first channel 50 comprises flip-flops L1, L2, L3 and a NAND gate 54 and the second channel 52 comprises flip-flops L4, L5, L6 and a NAND gate 56. The channels 50, 52 are wired nearly identically to the known circuit illustrated in Figure 3, with the asynchronous signal on the lead 11 being applied to the clock inputs of the pulse edge detectors of the gate enabled flip-flops L3, L6. In this case, however, the flip-flops L3, L6 have enable inputs which are connected to the Q-not and Q outputs of the flip-flop L7. The flip-flop L7 has its D input connected to its Q-not output, and has it clock input connected to receive the asynchronous signal on the lead 11. The re-set input of the flip-flop L7 is connected to receive an external re-set pulse on a lead 58. The Q outputs of the flip-flops L2, L5 provide respective separate synchronous output signals SYNCH 1 and SYNCH 2.

In the operation of the circuit illustrated in Figure 5, the initial state of the flip-flop L7 is unimportant. However, upon receipt of a re-set pulse 60, the flip-flop L7 is forced low so that its Q output is low and its Q-not output is high. The high Q-not output of the flip-flop L7 disables the gate input of the flip-flop L3 while the low Q output of the flip-flop L7 enables the gate input of the flip-flop L6. Upon receipt of a first asynchronous pulse 62, the enable flip-flop L6 responds to the pulse and forces its Q output high to generate a high pulse 64. Upon a next clock pulse 66, the Q output of the flip-flop L4 generates a high pulse 68. Upon a next pulse 70, a high SYNCH 2 pulse is generated thereby providing the conditions for operation of the NAND gate 56 to provide a re-set pulse 74 to force the Q outputs of the flip-flops L4, L6 low and to force pulses 64, 68 low. The SYNCH 2 pulse 72 is forced low with the leading edge of a next clock pulse 82 re-setting the flip-flop L2.

The asynchronous pulse 62 also sets the flip-flop L7 so that the Q output thereof is high to disable the flip-flop L6 and the Q-not output of the flip-flop L7 is low to enable the flip-flop L3. As a result, upon a next synchronous pulse 76, the Q output of the flip-flop L3 is forced high to produce a pulse 78 so that the clock pulse 70 forces the flip-flop L1 to generate a high pulse 80. At the leading edge of a next clock pulse 82, a SYNCH 1 pulse 84 is generated, and the NAND gate 54 provides a re-set pulse 86 to re-set flip-flops L1, L3 to force pulses 78, 80 low. The SYNCH 1 pulse 84 will be forced low at the next clock pulse. The asynchronous pulse 76 also serves to re-set the flip-flop L7 to force the Q-not output of the flip-flop L7 high and the Q output of the flip-flop L7 low. Hence, the circuit is permitted to begin a fresh cycle with successive asynchronous pulses.

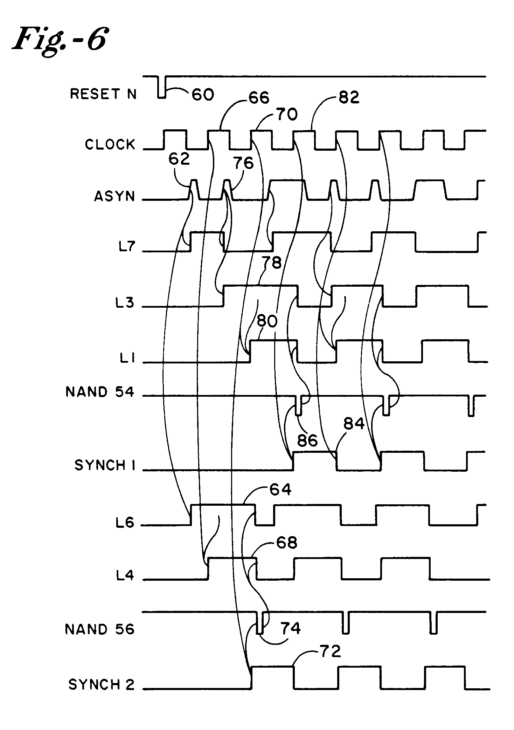

The SYNCH 1 and SYNCH 2 signals in Figure 6 may be processed, such as through enable gates of subsequent circuitry, to utilise the now synchronous pulses 72, 84 and any digital information contained in or accompanying the pulses. Such successive circuitry might, for example, be responsive to a sequence in which the synchronous pulses are presented to maintain the same sequence as the corresponding asynchronous pulses were received.

Noteworthy, the flip-flop L7 operates as a two position shift register with its Q and Q-not outputs enabling the separate edge formers of the flip-flops L3, L6. As a result, each channel 50, 52 operates to synchronise the asynchronous data for alternate pulses of the asynchronous signal on the line 11. The channels are enabled and the clock signals are settled before an asynchronous pulse is to be processed by the channel. The result is that metastable conditions in either channel will become stabilised before the channel is called upon to again detect an asynchronous pulse. Thus, the present invention provides an effective circuit for eliminating the effects of metastable conditions in asynchronous pulse recovery.

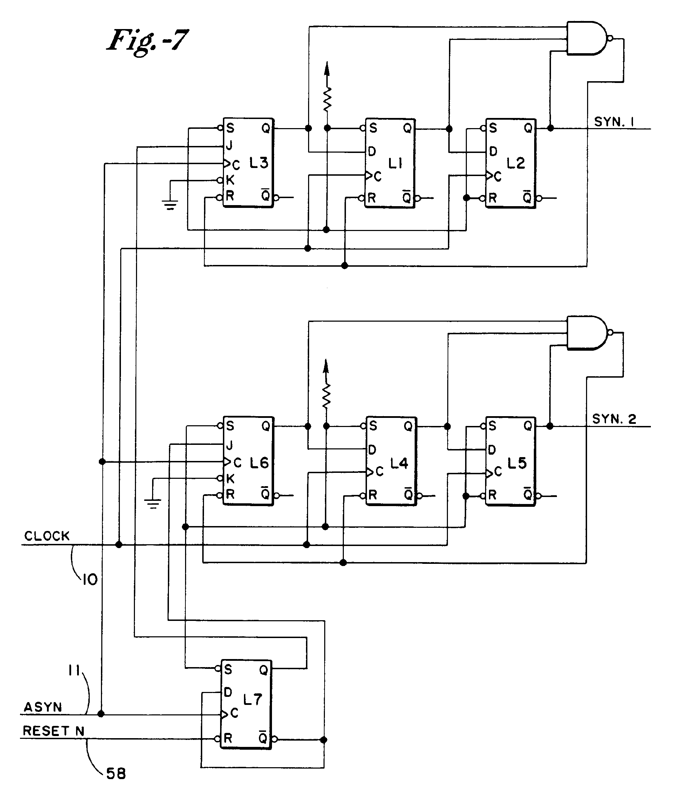

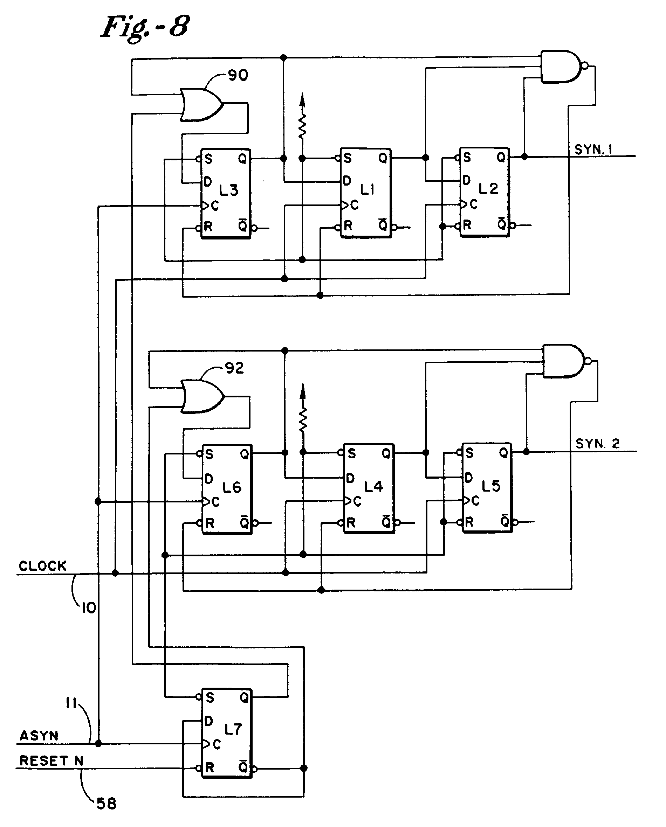

Figures 7 and 8 illustrate modifications to the circuit of Figure 5 employing different types of pulse edge detectors L3, L6.

In Figure 7, instead of enabling type of D-type flip-flops L3, L6 as in Figure 5, the flip-flops L3, L6 in Figure 7 are J - K flip-flops, having their K inputs grounded and their J inputs connected to the Q and Q-not outputs of the shift register formed by the flip-flop L7.

In Figure 8, standard D-type flip-flops are employed with the Q and Q-not outputs of the shift register formed by the flip-flop L7 operating through OR gates 90, 92 to the D inputs of the respective flip-flops L3, L6. A second input for the OR gate 90, 92 are taken from the respective Q outputs of the respective flip-flops. The circuit illustrated in Figures 7 and 8 operate in essentially the same manner as the circuit illustrated in Figure 5, and need not be further explained.

The present invention thus provides a metastable prevent circuit effectively eliminating metastable conditions in data recovery circuits which synchronise asynchronous data signals. The circuit is effective in operation and use, and enables recovery at high data speeds.

In the case of a two channel circuit, the shift register may be a two position shift register (i.e. a bistable multi-vibrator or a flip-flop), which will enable the channels alternately. The channels thus independently receive and process half the asynchronous data, thereby eliminating the effects of metastable conditions.

One feature of the present invention resides in the fact that metastability is eliminated because each channel is enabled and is clocked to recover before the next asynchronous data pulse is received for processing on that channel.

Another feature of the present invention resides in the fact that the system is easily expanded for additional parallel channels operating off additional positions of an expanded shift register, thereby providing greater time periods for recovery of each channel.

## Claims

1. A metastable prevent circuit comprising a plurality of channels (50; 52) disposed in parallel, each channel including a pulse edge detector (L3, L6) and bistable means (L1, L2; L4, L5) coupled to the output of said pulse edge detector, whereby said pulse edge detector is responsive to asynchronous pulses and said bistable means (L1, L2; L4, L5) synchronises said asynchronous pulses to clock pulses of a synchronous clock signal, a selection means (L7) coupled to each channel for producing an enable signal to successively enable each one of the pulse edge detectors (L3, L6), characterised by the selection means being responsive to said asynchronous pulses.

2. A circuit as claimed in Claim 1, characterised in that each of said bistable means comprises first bistable means (L1; L4) responsive to a first clock pulse to produce a first output and second bistable means (L2; L5) responsive to a second clock pulse following said first clock pulse and to said first output to produce said synchronous pulses.

3. A circuit as claimed in Claim 2, characterised in that each of said pulse edge detector means (L3;L6) comprises third bistable means and gate means (54; 56) responsive to the output of said first, second and third bistable means (L3, L1, L2; L6, L4, L5) to reset said first and third bistable means (L1, L4; L2, L5).

4. A circuit as claimed in Claim 3, characterised in that said third bistable means (L3; L6) is either a gate enabled flip-flop having its enable input connected to an individual output of said selection means (L7), or a J-K flip-flop having its J input connected to an individual output of said selection means (L7).

5. A circuit as claimed in claim 3, characterised in that said third bistable means (L3; L6) is a D-type flip-flop having its D input connected to an individual output of said selection means (L7).

6. A circuit as claimed in claim 5, characterised by including OR gate means (90; 92) having a first input connected to said individual output of said selection means (L7), a second input connected to the true output of said D-type flip-flop, and an output connected to said D-input.

7. A circuit as claimed in any preceding claim in which said selection means comprises a forth bistable means (L7).

## Patentansprüche

1. Schaltung zur Verhinderung eines metastabilen Zustandes, mit einer Mehrzahl von Kanälen (50;52), die parallel zueinander angeordnet sind, wobei jeder Kanal einen Impulsflankendetektor (L3,L6) und bistabile Einrichtungen (L1,L2;L4,L5) einschließt, die mit dem Ausgang des Impulsflankendetektors gekoppelt sind, wobei der Impulsflankendetektor auf asynchrone Impulse anspricht und die bistabile Einrichtungen (L1,L2;L4,L5) die asynchronen Impulse mit Taktimpulsen eines synchronen Taktsignals synchronisiert, wobei eine Auswahleinrichtung (L7) mit jedem Kanal verbunden ist, um ein Freigabesignal zu erzeugen, um aufeinanderfolgend jeweils einen der Impulsflankendetektoren (L3,L6) freizugeben,
dadurch gekennzeichnet, daß die Auswahleinrichtung auf die asynchronen Impulse anspricht.

2. Schaltung nach Anspruch 1,
dadurch gekennzeichnet, daß jede der bistabilen Einrichtungen eine erste bistabile Einrichtung (L1;L4), die auf einen ersten Taktimpuls anspricht, um ein erstes Ausgangssignal zu erzeugen, und eine zweite bistabile Einrichtung (L2;L5) umfaßt, die auf einen zweiten, auf den ersten Taktimpuls folgenden Taktimpuls und auf das erste Ausgangssignal anspricht, um die synchronen Impulse zu erzeugen.

3. Schaltung nach Anspruch 2,
dadurch gekennzeichnet, daß jede der Impulsflankendetektoreinrichtungen (L3;L6) eine dritte bistabile Einrichtung und eine Verknüpfungsgliedeinrichtung (54;56) umfaßt, die auf das Ausgangssignal der ersten, zweiten und dritten bistabilen Einrichtung (L3,L1,L2;L6,L4,L5) anspricht, um die erste und die dritte bistabile Einrichtung (L1,L4;L2,L5) zurückzusetzen.

4. Schaltung nach Anspruch 3,
dadurch gekennzeichnet, daß die dritte bistabile Einrichtung (L3;L6) entweder eine durch ein Verknüpfungsglied freigegebene Flip-Flop-Schaltung, deren Freigabeeingang mit einem einzelnen Ausgang der Auswahleinrichtung (L7) verbunden ist, oder eine J-K-Flip-Flop-Schaltung ist, deren J-Eingang mit einem einzelnen Ausgang der Auswahleinrichtung (L7) verbunden ist.

5. Schaltung nach Anspruch 3,
dadurch gekennzeichnet, daß die dritte bistabile Einrichtung (L3;L6) eine D-Flip-Flop-Schaltung ist, deren D-Eingang mit einem einzelnen Ausgang der Auswahleinrichtung (L7) verbunden ist.

6. Schaltung nach Anspruch 5,
dadurch gekennzeichnet, daß sie ODER-Verknüpfungsglieder (90; 92) einschließt, die einen mit dem einzelnen Ausgang der Auswahleinrichtung (L7) verbundenen ersten Eingang, einen zweiten, mit dem nicht invertierten Ausgang der D-Flip-Flop-Schaltung verbundenen Eingang und einem mit dem D-Eingang verbundenen Ausgang aufweisen.

7. Schaltung nach einem der vorhergehenden Ansprüche, bei der die Auswahleinrichtung eine vierte bistabile Einrichtung (L7) umfaßt.

## Revendications

1. Circuit métastable de prévention comprenant une pluralité de voies (50 ; 52) montées en parallèles, chaque voie comportant un détecteur (L3, L6) de front d'impulsion et des moyens bistables (L1, L2 ; L4, L5) couplés à la sortie dudit détecteur de front d'impulsion, grâce à quoi ledit détecteur de front d'impulsion répond à des impulsions asynchrones et lesdits moyens bistables (L1,
L2 ; L4, L5) synchronisent lesdites impulsions asynchrones sur des impulsions d'horloge d'un signal d'horloge synchrone, un moyen (L7) de sélection, couplé à chaque canal, pour former un signal de validation qui valide successivement chacun des détecteurs (L3, L6) de front d'impulsion, caractérisé par des moyens de sélection qui sont sensibles auxdites impulsions asynchrones.

2. Circuit selon la revendication 1, caractérisé en ce que chacun desdits moyens bistables comprend un premier moyen bistable (L1 ; L4) répondant à une première impulsion d'horloge pour former une première sortie et un second moyen bistable (L2 ; L5) qui répond à une seconde impulsion d'horloge arrivant après ladite première impulsion d'horloge, et à ladite première sortie pour former lesdites impulsions synchrones.

3. Circuit selon la revendication 2, caractérisé en ce que chacun desdits moyens détecteurs (L3 ; L6) de front d'impulsions comporte un troisième moyen bistable et un moyen (54, 56) de porte qui répondent à la sortie desdits premier, second et troisième moyens bistables (L3, L1, L2 ; L6, L4, L5) pour amener à l'état initial lesdits premier et troisième moyens bistables (L1, L4 ; L2, L5).

4. Circuit selon la revendication 3, caractérisé en ce que ledit troisième moyen bistable (L3, L6) est soit une bascule validée par une porte ayant son entrée de validation reliée à une sortie individuelle dudit moyen (L7) de sélection, soit une bascule J-K ayant son entrée J reliée à une sortie individuelle dudit moyen (L7) de sélection.

5. Circuit selon la revendication 3, caractérisé en ce que ledit troisième moyen bistable (L3 ; L6) est une bascule de type D ayant son entrée D reliée à une sortie individuelle dudit moyen (L7) de sélection.

6. Circuit selon la revendication 5, caractérisé en ce qu'il comprend un moyen (90 ; 92) de porte OU, ayant une première entrée reliée à ladite sortie individuelle dudit moyen (L7) de sélection et une seconde entrée reliée à la sortie vraie de ladite bascule de type D, et une sortie reliée à ladite entrée D.

7. Circuit selon l'une quelconque des revendications précédentes, dans lequel ledit moyen de sélection est constitué par un quatrième moyen bistable (L7).
